# EUROPEAN PATENT APPLICATION

(11) **EP 1 890 370 A2**
(43) Date of publication of application: **20.02.2008**
(21) Application number: 07016156.7
(22) Date of filing: 17.08.2007
(51) Int. Cl.: H02J 7/00

(54) **Monitoring battery cell voltage**

(30) Priority: 17.08.2006 US 838551 P; 15.08.2007 US 893155
(71) Applicant: O2Micro, Inc., Santa Clara, CA 95054 (US)
(72) Inventor: Bucur, Constantin, Santa Clara, CA 95051 (US)
(74) Representative: Jungen, Rolf

(57) **Abstract**

A battery monitoring circuitry is provided. The battery monitoring circuitry includes a plurality of voltage detection paths and a logic device. Each voltage detection path is coupled to a battery cell and is operable for comparing a cell voltage of the battery cell with a switch threshold of a switch. Each voltage detection path is ON if the cell voltage is greater than the switch threshold. The logic device is coupled to the plurality of voltage detection paths and is operable for generating an alert signal according to a conductance status of each voltage detection path.

## Description

### CROSS-REFERENCE TO RELATED APPLICATIONS

This application claims priority of co-pending provisional application, serial number 60/ 838,551, filed on August 17, 2006, which is hereby incorporated by reference in its entirety. This application is also a continuation-in-part of the co-pending U.S. application, serial number 11/457,932, filed on July 17, 2006, which is hereby incorporated by reference in its entirety.

### FIELD OF THE INVENTION

This disclosure relates to voltage monitoring, and more particularly, to monitoring battery cells in a battery pack.

### BACKGROUND

Some electrical devices such as power tools, electrical vehicles and other portable devices may be powered by battery packs. By attaching a cordless battery pack to a power tool, a user is free to move about without being constrained by a power cord.

A battery pack may include battery cells and switching circuitry for allowing the battery cells to supply power or be charged. One or more monitoring functions may be performed by circuitry included in the battery pack to maintain a safe use of the battery cells. For example, the voltage levels present on each battery cell may be monitored.

Certain battery cell chemistries e.g., lithium-ion cells, may become hazardous if their voltage level exceeds a high voltage threshold or drops below a low voltage threshold. Accordingly, conventional circuitries may monitor battery cell voltage and compare the monitored voltage to predefined low and high voltage thresholds. If either threshold is reached, a safety function (e.g., increase monitoring rate, open a switch, etc.) may be initiated. However, determining that a threshold breech may take a considerable period of time, and such a long period of time may exceed safety limits of the battery.

Furthermore, existing methods include using classic analog comparators and introducing a reference voltage in the monitoring circuit. As a result, the conventional art significantly increases detection time and the power consumption, especially when multiple cells are monitored in a battery pack.

### SUMMARY OF THE INVENTION

In accordance with one aspect of the invention, a monitoring circuitry for monitoring battery cell voltages is presented. The monitoring circuitry includes a plurality of voltage detection paths and a logic device. Each voltage detection path is coupled to a battery cell and is operable for comparing a cell voltage of the battery cell with a switch threshold of a switch. Each voltage detection path is ON if the cell voltage is greater than the switch threshold. The logic device is coupled to the plurality of voltage detection paths. According to a conductance status of each voltage detection path, the logic device generates an alert signal.

### BRIEF DESCRIPTION OF THE DRAWINGS

Features and advantages of embodiments of the claimed subject matter will become apparent as the following detailed description proceeds, and upon reference to the drawings, wherein like numerals depict like parts, and in which:

FIG. 1 illustrates a diagrammatic view of a power tool that includes a battery pack, in accordance with one embodiment of the present invention.

FIG. 2 illustrates an exemplary block diagram that represents portions of the battery pack shown in FIG.1, in accordance with one embodiment of the present invention.

FIG. 3 illustrates an exemplary block diagram that represents an exemplary gas gauge circuitry that monitors the voltage levels present on the battery cells shown in FIG. 2, in accordance with one embodiment of the present invention.

FIG. 4 illustrates a flowchart that represents some of the operations of a controller included in the gas gauge circuitry shown in FIG. 2, in accordance with one embodiment of the present invention.

FIG. 5 illustrates an exemplary block diagram that represents an exemplary gas gauge circuitry which includes a monitoring circuit for monitoring voltages present on the battery cells shown in FIG. 2, in accordance with one embodiment of the present invention.

FIG. 6 illustrates another exemplary block diagram that represents an exemplary gas gauge circuitry which includes a monitoring circuit for monitoring voltages present on the battery cells shown in FIG. 2, in accordance with one embodiment of the present invention.

FIG. 7 illustrates a flowchart that represents a method of monitoring battery cell voltages, in accordance with one embodiment of the present invention.

### DETAILED DESCRIPTION

Reference will now be made in detail to the embodiments of the present invention. While the invention will be described in conjunction with these embodiments, it will be understood that they are not intended to limit the invention to these embodiments. Additional advantages and aspects of the present disclosure will become readily apparent to those skilled in the art from the following detailed description. As will be described, the present disclosure is capable of modification in various obvious respects, all without departing from the spirit of the present disclosure. Accordingly, the drawings and description are to be regarded as illustrative in nature, and not as limitative.

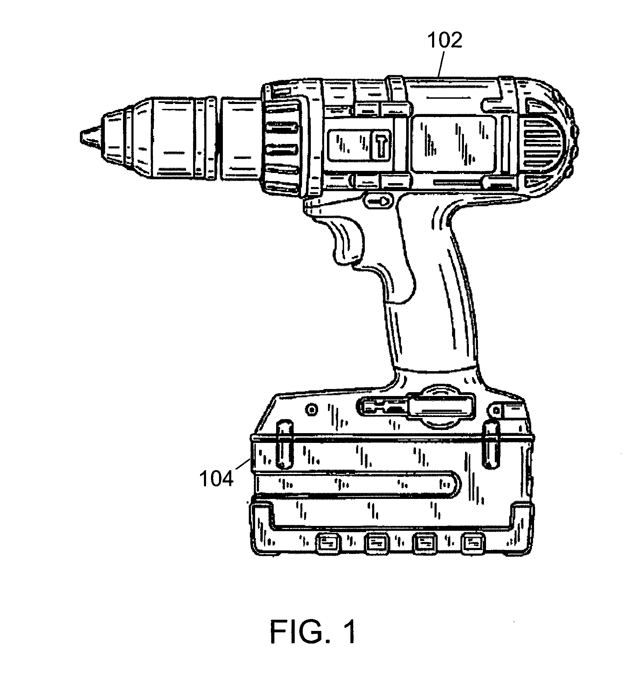

Referring to FIG. 1, an exemplary cordless power tool 100 may include a drill 102 and a battery pack 104. Drill 102 may be fitted with one or more drill bits, screwdriver heads, etc., for performing a variety of operations (e.g., drilling a hole, inserting and/or removing a screw, etc.). While this exemplary power tool includes a drill, other embodiments may include other types of electrical tools and/or devices (e.g., vacuum cleaners, circular saw, drill, flood light, laser guide/level, etc.).

Typically, battery pack 104 may include a power source (e.g., battery cells) for supplying power to drill 102. By providing a cordless power source, a user may freely roam and use cordless power tool 100 without being constrained by a power cord connected to a wall socket. Along with providing power, during some periods battery pack 104 may share data with a computing device (not shown) via a digital or analog data bus e.g., a wireless link (not shown), a parallel cable (not shown), a universal serial bus cable (not shown), and/or a network cable. Shared data may include status data (e.g., power source charge level, drill operating or idle, etc.), identification data (e.g., drill manufacturer, battery cell type included in battery pack, etc.), and/or other type information.

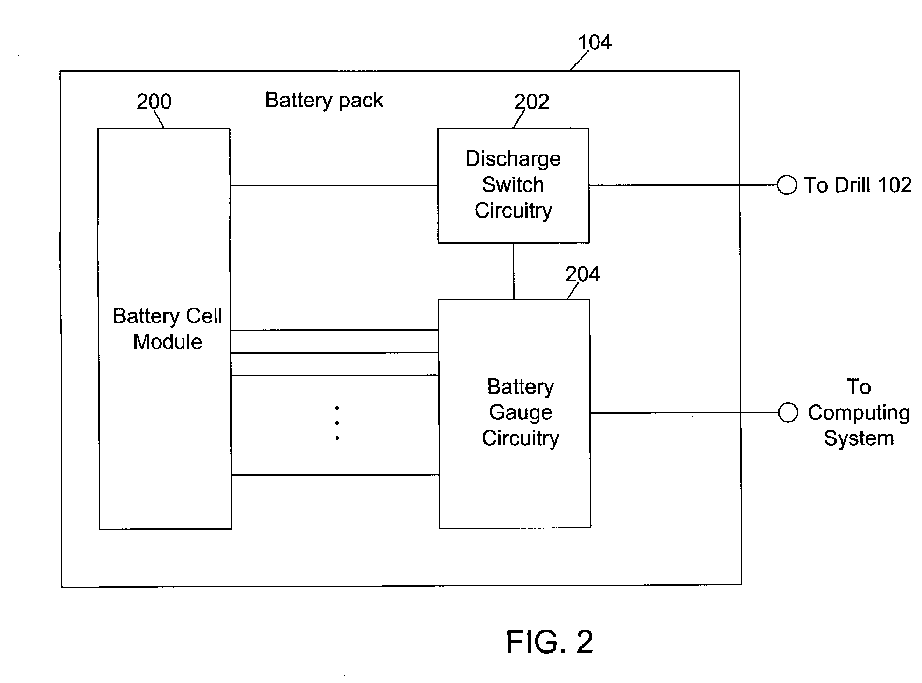

Referring to FIG. 2, a block diagram of battery pack 104 is shown. Battery pack 104 may include a battery cell module 200, power control switch circuitry (discharge switch circuitry) 202 and battery gauge (gas gauge) circuitry 204. Battery cell module 200 may include a group of battery cells or other type of energy storage device (e.g., fuel cells, etc.) that may provide power to one or more loads (e.g., a motor) included in drill 102. To control the power being delivered to drill 102, battery cell module 200 may be connected to power control switch circuitry 202. For example, if the power being provided drops below a predefined threshold, power control switch circuitry 202 may open the connection between battery cell module 200 and the motor of drill 102. Alternatively, if an appropriate amount power may be provided by the battery cell module 200, power control switch circuitry 202 may allow power delivery by closing the connection between the battery cell module 200 and the motor of drill 102.

Battery gauge circuitry 204 may control power control switch circuitry 202 in regards to connecting or disconnecting battery cell module 200 and the motor of drill 102. To provide this control, battery gauge circuitry 204 may monitor battery cell module 200. For example, battery gauge circuitry 204 may monitor voltage present on one or more battery cells that may be included in battery cell module 200. If the voltage present on one or more battery cells drops below (or rises above) a predefined level, battery gauge circuitry 204 may trigger power control switch circuitry 202 to open the connection between battery cell module 200 and the motor or drill 102. Alternatively, if the voltage present on the battery cells is within a safe operating range, battery gauge circuitry 204 may cause power control switch circuitry 202 to close the connection between battery cell module 200 and the motor of drill 102.

Along with controlling the operation of power control switch circuitry 202, battery gauge circuitry 204 may transmit and/or receive information from a computing system (not shown) that may be connected to battery pack 104. For example, battery gauge circuitry 204 may transmit data that may represent the voltage level present on one or more of the battery cells included in battery cell module 200. Data may also be provided to the computing system that identifies the individual battery cell (or battery cells) that are not operating within the predefined safe range. Data transmission may be scheduled, for example, on a periodic basis and/or based on the occurrence of particular events. For example, data that represents the voltage present on each battery cell may be transmitted at one or more times each second. In regards to transmissions triggered by one or more events, the voltage data may be transmitted whenever the motor of drill 102 may idle and may not be drawing power from battery pack 104. Battery gauge circuitry 204 may also implement one or more data transmission schemes (e.g., compression, encoding, encryption, etc.) and/or reception schemes (e.g., decompression, decoding, decryption, etc.) to share information with the one or more connected computing systems.

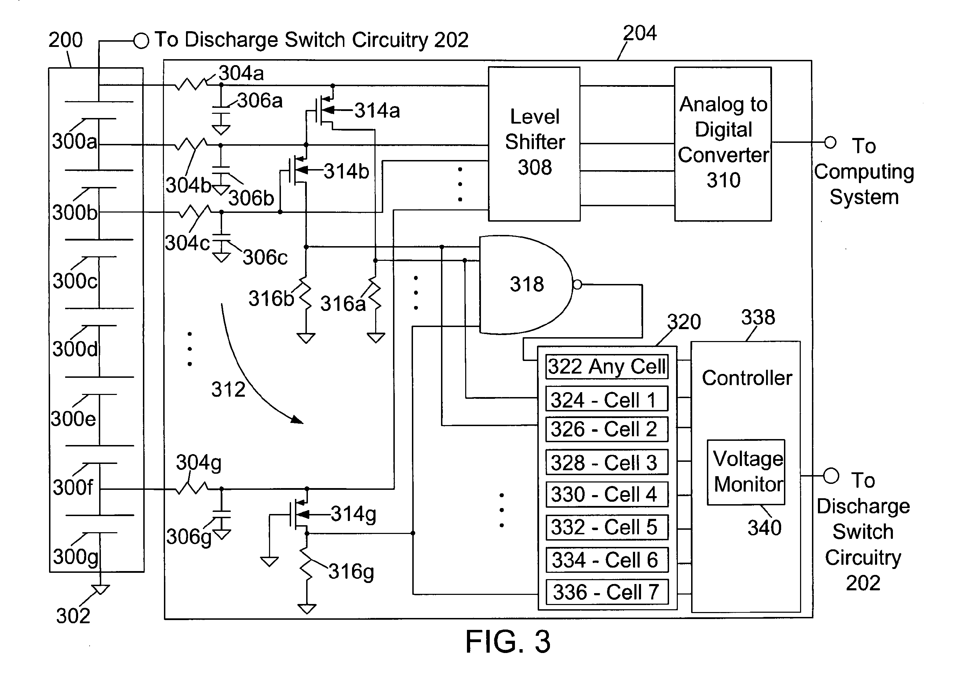

Referring to FIG. 3, a block diagram of battery cell module 200 and battery gauge circuitry 204 is shown. Battery cell module 200 may include one or more battery cells or other type of energy storage devices (e.g., fuel cell, etc.) that may be used to power the motor of drill 102. In this embodiment, battery cell module 200 may include seven battery cells 300a, 300b, 300c, 300d, 300e, 300f and 300g, however, more or less battery cells may be implemented. Battery cells may be connected in series such that the voltage provided by battery cell module 200 may be substantially equivalent to the sum of the voltages present on each of battery cells 300a-g. To provide this summed voltage, battery cell 300a may be connected to power control switch circuitry 202 (that may provide the voltage to the motor of drill 102). In this embodiment, battery cell 300g may be connected to a ground terminal 302.

To monitor the voltage present on each battery cell 300a-g, one side of each battery cell may be connected to the battery gauge circuitry 204. In one embodiment the positive terminal of each battery cell 300a-g may be connected to the battery gauge circuitry 204. Each positive terminal may be connected to an individual low pass filter that includes a resistor and capacitor. For example, battery cell 300a may be connected to a low pass filter that includes a resistor 304a and a capacitor 306a. Similarly, battery cells 300b-g may be connected to low pass filters that respectively include resistors 304b-g and capacitors 306b-g.

Once filtered by the respective low pass filters that may include resistors 304a-g and capacitors 306a-g, the voltage present on battery cells 300a-g may be provided to a level shifter 308. Level shifter 308 may condition (e.g., raise the voltage level, lower the voltage level, filter, etc.) each voltage signal in preparation for being converted from the analog domain into the digital domain. In this embodiment, level shifter 308 provides the conditioned voltage signals to an analog to digital converter (ADC) 310 that may convert each analog voltage signal into a digital signal (e.g., an 8-bit binary number, a 12-bit binary number, etc.). ADC 310 may implement one or more conversion techniques (e.g., flash converter, successive approximation converter, sigma-delta converter, etc.). Additionally, while a single ADC 310 may be included in battery gauge circuitry 204, in some embodiments, more than one ADC's may be implemented.

ADC converter 310 may provide one or more digital signals (that represent the voltage present at each battery cell 300a-g) to a computing system (not shown). This computing system may be incorporated into cordless power tool 100 and/or be located remote (via a wireless link or other type of connection) from the cordless power tool. By providing this voltage level representation to the computing system, a voltage reduction on one or more of battery cells 300a-g may be detected. Once detected, one or more control signals may be sent to discharge switch circuitry 202 to halt delivery of power from battery module 200 to the motor of power drill 102. Additionally, by providing the voltage level of each battery cell 300a-g, the computing system may identify which one (or more) of the battery cells have a reduced voltage level. Once identified, the deficient battery cell or cells may be recharged to replenish their voltages to an appropriate level. Along with sensing a reduced voltage level (on one or more battery cells), other events may be monitored. For example, voltage levels that exceed a predefined threshold may be detected and/or other types of events (e.g., temperature within battery module 200 exceeding a threshold, etc.).

Typically, ADC 310 may generate one or more digital signals that represent the voltage present on each battery cell 300a-g. These battery cell voltages may be sampled by ADC 310 in a repetitive manner over a period of time. For each sample period, ADC 310 may generate and provide one or more digital signals to the computing system. Thereby, the voltage present on each battery cell may be monitored over a period of time. Such repetitive converting by ADC 310 may consume a considerable amount of power. Additionally, by repetitively generating one or more digital signals over a period of time, substantial processing time and resources may be needed from battery gauge circuitry 204 and the computing system. Furthermore, the time needed for processing these signals may delay detecting a voltage reduction on one or more battery cells and/or identifying the deficient battery cell (or cells).

Detection time for determining if voltage may have been reduced on one or more of battery cells 302a-g may be decreased by including a dedicated processing path 312 in battery gauge circuitry 204. Processing path 312 may also reduce the processing time to identify the one or more battery cells 300a-g that may have a reduced voltage level. By incorporating components such as combination logic devices in processing path 312, power consumption and processing time may be substantially reduced compared with using ADC 310. For example, ADC 310 may need milli-seconds of processing time (e.g., seven milli-seconds) for converting and transferring the digital data to the computer system. In comparison, processing path 312 may need a few micro-second clock cycles (e.g., 2 clock cycles (2 micro-seconds)) to determine if one or more of battery cells 300a-g has experienced a voltage reduction.

To provide this functionality, processing path 312 may include additional circuitry and/or components. For example, switches 314a, 314b, 314c (not shown), 314d (not shown), 314e (not shown), 314f (not shown) and 314g may be included in battery gauge circuitry 204. Resistors 316a, 316b, 316c (not shown), 316d (not shown), 316e (not shown), 316f (not shown) and 316g may also be included in battery gauge circuitry 204. One or more combinational logic components such as a NAND gate 318 may be included in processing path 312. For storing data that represents the status of the voltage present at each battery cell 300a-g, a group of registers 320 may be included in path 312. In this embodiment, register group 320 includes eight registers 322, 324, 326, 328, 330, 332, 334 and 336. To access one or more of the registers 322-336, a controller 338 may be included in processing path 312. Along with determining if one or more of battery cells 300a-g may have experienced a voltage reduction, controller 322 may identify the one or more cells that may have experienced a voltage reduction.

Switches 314a-g may respectively connect between capacitors 306a-g and level shifter 308. In this embodiment, each of switches 314a-g may be implemented as P-channel metal oxide semiconductor field effect transistors (MOSFETs). However, in some embodiments other types of field effect transistors (e.g., N-channel MOSFETs) and/or other types of transistors (e.g., bipolar junction transistors) may be used to implement one or more of switches 314a-g. The voltages present on battery cells 300a-g may substantially bias the respective switches 314a-g. For example, a signal that represents the voltage present at battery cell 300a may be provided (via resistor 304a and capacitor 306a) to switch 314a. If the voltage may be substantially equivalent to or above a predefined threshold, switch 314a may be biased to close. If biased closed, a signal that represents the voltage present on battery 300a may be provided to a resistor 316a (via switch 314a). Based on the received signal from switch 314a, a voltage may be present across resistor 316a. For example, if an appropriate voltage is present at battery cell 300a, switch 314a may be biased closed and a voltage representative of the voltage at battery cell 300a may be present across resistor 316a.

Alternatively, the voltage present on battery cell 300a may not bias switch 314a to close. For example, the voltage present at battery cell 300a may be below a predefined threshold needed to bias switch 314a. Due to power delivery, this voltage reduction may be experienced by battery 300a. Since switch 314a may not be biased to close, a relatively small amount of current may flow to resistor 316a. Thereby, a relatively low voltage may be present across resistor 316a. This low voltage may be detected by controller 338.
Furthermore, based on this low voltage, controller 338 may identify battery cell 300a as being under-voltage and initiate an appropriate response (e.g., disconnect the load and/or recharge battery cell 300a). Similar to resistor 316a, resistors 316b-g may be used by controller 338 for detecting if one or more of battery cells 316b-g may have experienced a voltage reduction. Additionally, the voltages present across resistors 316b-g may assist controller 338 in identifying the one or more battery cells that have experienced a low voltage fault condition. To that end, an interrupt circuitry 342 (not shown) may generate an interrupt to controller 338 indicative of a fault condition. The interrupt generated by the interrupt circuitry 342 may cause controller 338 to enter a protection mode to disable battery discharging to protect cells in an under-voltage condition. The output of NAND gate 318 may be used to trigger an interrupt (via interrupt circuitry 342) to controller 338 if, for example, the output of the NAND gate 318 is a logic "1 ". This may cause controller 338 to read from the registers 320 in a manner described herein.

To detect if the one or more of voltages present battery cells 300a-g is reduced, each of resistors 316a-g may be connected to an input of NAND gate 318. For this embodiment NAND gate 318 may include seven inputs (e.g., one for each resistor 316a-g). Based on the logical functionality of NAND gate 318, a logic "0" may be output if a logic "1" is present on each input to the gate. Accordingly, if any input to NAND gate 318 may be logic "0", the output of the gate may be logic "1". So, if one or more of switches 314a-314g may not be biased closed, a voltage present on the respective one or more of resistors 316a-g may be relatively low. Accordingly, this relatively low voltage may be considered a logic "0" being input to NAND gate 318. Thereby, if one or more inputs of NAND gate 318 are provided logic "0", logic "1" may be outputted by NAND gate 318. So, if a voltage reduction may be experienced at one or more of battery cells 300a-g, logic "1" may be outputted from NAND gate 318. This logic "1" may be used by controller 338 to detect a voltage reduction at one or more of battery cells 300a-g. In this embodiment NAND gate 318 provides the logical operations for detecting a voltage reduction. However, in some embodiments other types of combination logic (e.g., AND gates, OR gates, Exclusive OR gates. NOR gates, etc.) may be implemented individually or in combination. By using a combination logic device (e.g., NAND gate 318), one or more voltage reductions may be detected in a relatively short time period (e.g., 2 clock cycles). Additionally, by using combinational logic, less power is consumed compared to the power draw by ADC 310.

In this embodiment, the output of NAND gate 318 may be provided to register group 320. In particular, the output (e.g., logic "1" if one or more of battery cells 300a-g experience a voltage reduction) may be provided to register 322 (labeled "Any Cell"). By storing data (that represents the output of NAND gate 318) in register 322, the data may be used by controller 338 for executing operations. For example, controller 338 may use the data to determine if a voltage reduction has been experienced by one or more of battery cells 300a-g. If a reduction has been experienced, controller 338 may, e.g., send a signal to discharge switch circuitry 202 for halting power delivery to the motor of drill 102.

Data may also be provided to register group 320 that represents the voltage present on each of resistors 316a-g. In this embodiment, each input (e.g., seven inputs) of NAND gate 318 may be connected to register group 320. Due to the connections, each individual input may be assigned to one register included in register group 320. For example, the input connected to resistor 316a may be assigned to register 324 (labeled "Cell 1"). Correspondingly, inputs connected to resistors 316b-316g may be assigned to respective registers 326-336. Data may be entered into individual registers to represent if a voltage reduction may have occurred. For example, if voltage reduces at battery cell 300a, the voltage across resistor 316a may be relatively low (as provided via switch 314a not being biased closed). This reduced voltage across resistor 316a may represent logic "0" if the voltage may be below a predefined threshold. Accordingly, logic "0" may be entered into the register 324 to indicate the voltage reduction present at battery cell 300a. Alternatively, if an appropriate voltage is present at battery cell 300a, a voltage may be present across resistor 316a (as provided by switch 314a being biased closed). In this scenario, logic "1" may be entered into the register 322. Similar data may be entered into registers 326-336 to indicate the voltage present at respective battery cells 300b-g. Thus, switches 314a-g and resistors 316a-g provide the status of each battery cell 300a-g to register group 320 in a substantially passive manner and in a relative short period of time.

Controller 338 may access one or more of the registers in register group 320 to determine if a voltage reduction has occurred at one or more of battery cells 300a-g. Additionally, controller 338 may access one or more registers 322-336 to identify which of the one or more battery cells have a deficient voltage level. Controller 338 may be implemented as one or more general processors (e.g., a microprocessor) or by one or more specialized devices (e.g., an application specific integrated circuit (ASIC), etc.).
Controller 338 and/or register group 320 may be implemented in a single integrated circuit as a monolithic structure. Similarly battery gauge circuitry 204 may be implemented as a single integrated circuit as a monolithic structure. Register group 320 may also reside in memory (e.g., random access memory (RAM), read-only memory (ROM), static RAM (SRAM), etc.).

To determine if one or more of battery cells 300a-g may have reached the minimum allowed voltage, controller 322 may execute a voltage monitor 340. Along with determining if a voltage reduction may have occurred, executing voltage monitor 340 may also identify the particular battery cell (or cells) that may have experienced a voltage reduction. The voltage monitor 340 may be implemented in digital electronic circuitry, or in computer hardware, firmware, software, or in combinations of them. Voltage monitor 340 may also be implemented as a computer program product, e.g., a computer program tangibly embodied in an information carrier, e.g., in a machine-readable storage device (e.g., RAM, ROM, hard-drive, CD-ROM, etc.) or in a propagated signal. The computer program product may be executed by or control the operation of, data processing apparatus, e.g., a programmable processor, a computer, or multiple computers. A computer program may be written in one or more forms of programming languages, including compiled or interpreted languages, and it can be deployed in any form, including as a stand-alone program or as a module, component, subroutine, or other unit suitable for use in a computing environment. A computer program may be deployed to be executed on one computing device (e.g., controller, computer system, etc.) or on multiple computing devices (e.g., multiple controllers) at one site or distributed across multiple sites and interconnected by a communication network.

Voltage monitor 340 may access the register 322 to determine if one or more of switches 314a-g may be open (not biased closed) and the corresponding one or more battery cells that may have experienced a voltage reduction. For example, voltage monitor 340 may access register 322 and read the stored information. Based on this information, voltage monitor 340 may relatively quickly determine if one or more of switches 314a-g may be open. For example, if logic "0" may be represented by data stored in the register 322, voltage monitor 340 may determine that at least one switch is open. Alternatively, logic "1" may be represented in the data stored in register 322. By accessing and reading the data, voltage monitor 340 may determine that none of switches 314a-g may be open.

By determining that at least one of battery cells 300a-g may have experienced a voltage reduction, controller 338 may initiate an appropriate action or actions. For example, controller 338 may initiate generating a control signal that may be provided to discharge switch circuitry 202. Upon receiving the control signal, discharge switch circuitry 202 may open the connection between battery cell module 200 and the motor of drill 102. By opening the connection, power delivery may be halted since one or more of battery cells 300a-g may be in a hazardous low voltage state. Increasing the monitoring rate of battery cells 300a-g may also be an appropriate action. For example, upon determining one or more of battery cells 300a-g may have a reduced voltage, controller 338 may request that ADC 310 and the computing system monitor battery cells 300a-g.

Voltage monitor 340 may also identify the one or more battery cells that may have experienced a voltage reduction. For example, voltage monitor 340 may access each of registers 324-336 after detecting a voltage reduction on at least one battery cell (via the contents of register 322). In this embodiment, if one or more of registers 324-336 store data that represents logic "0", the associated battery cell may have experienced a voltage reduction. Alternatively, if one (or more) of registers 324-336 store data that may represent a logic "1", the associated battery cell may be presently charged to an appropriate level. By identifying the one or more battery cells with a reduced voltage level, controller 338 may generate a signal to initiate an appropriate action or actions (e.g., initiate recharging of the identified battery cells).

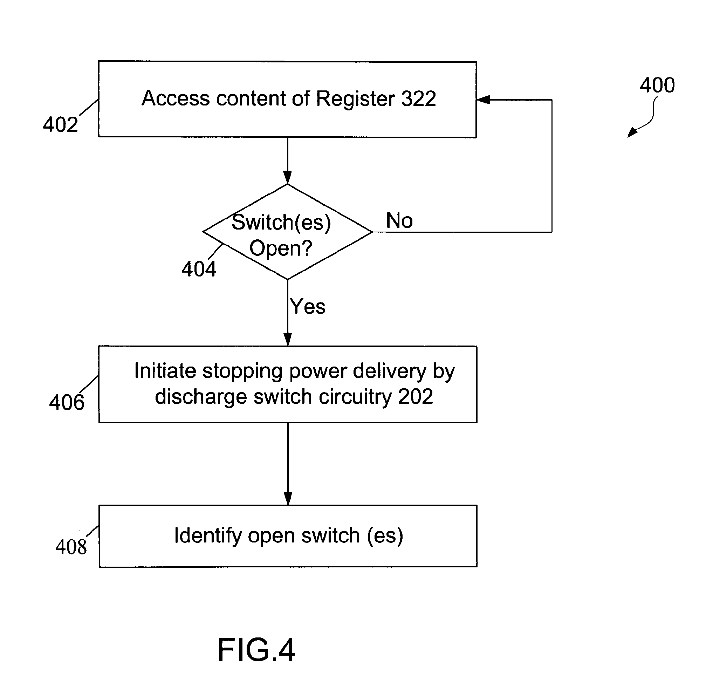

Fig. 4 presents a flowchart 400 that includes some of the operations of voltage monitor 340. For example, some operations may include accessing 402 register 322 to read the register content for determining if one or more of switches 314a-g may be open. An open switch may represent that a corresponding battery cell has experienced a voltage reduction. Operations may also include determining 404 if one or more of switches 300a-g may be open. For example, voltage monitor 340 may determine that register 322 may be storing data that represents logic "1". As provided by NAND gate 318, logic "1" may represent that one or more of switches 314a-g may be open. Alternatively, stored data may represent logic "0", and thereby represent that none of switches 314a-g may be open. If determined that none of switches 314a-g may be open, another operation may include returning to access 402 the content of register 322.

If determined that one or more of switches 314a-g may be open, other operations may include initiating 406 the stoppage of power delivery by discharge switch circuitry 202. Other operations may also include identifying 408 the open switches. By identifying the open switch (or switches), controller 338 may identify the respective battery cell (or battery cells) associated with the open switch (or switches). Once the battery cells have been identified, controller 338 may initiate one or more appropriate actions. For example, controller 338 may initiate recharging of the battery cells associated with the open switches.

One or more of the operations associated with flowchart 400 may be performed by one or more programmable processors (e.g., controller 338) executing a computer program to perform the operations by operating on input data (e.g., contents of register 322-336) and generating output (e.g., one or more control signals). The operations may also be performed by controller 338 implemented as special purpose logic circuitry (e.g., an FPGA (field programmable gate array), an ASIC (application-specific integrated circuit), etc.). In some arrangements one or more of the operations associated with flowchart 400 (along with other operations) may be dependent upon the type of power tool or portable device in which the battery cells are being monitored. For example, additional operations may be executed or operations may not be executed due to the portable device type.

In some embodiments controller 338 may be suitable for executing a computer program and may include, by way of example, general and/or special purpose microprocessors. In general, a processor may receive instructions and data from a memory (e.g., ROM, RAM, etc.). Controller 338 may be operatively coupled to receive data from or transfer data to, or both, one or more mass storage devices (e.g., magnetic, magneto-optical disks, or optical disks, etc.) for storing data. Information carriers suitable for embodying computer program instructions and data may include forms of non-volatile memory, including by way of example semiconductor memory devices, e.g., EPROM, EEPROM, and flash memory devices; magnetic disks, e.g., internal hard disks or removable disks; magneto-optical disks; and CD-ROM and DVD-ROM disks.

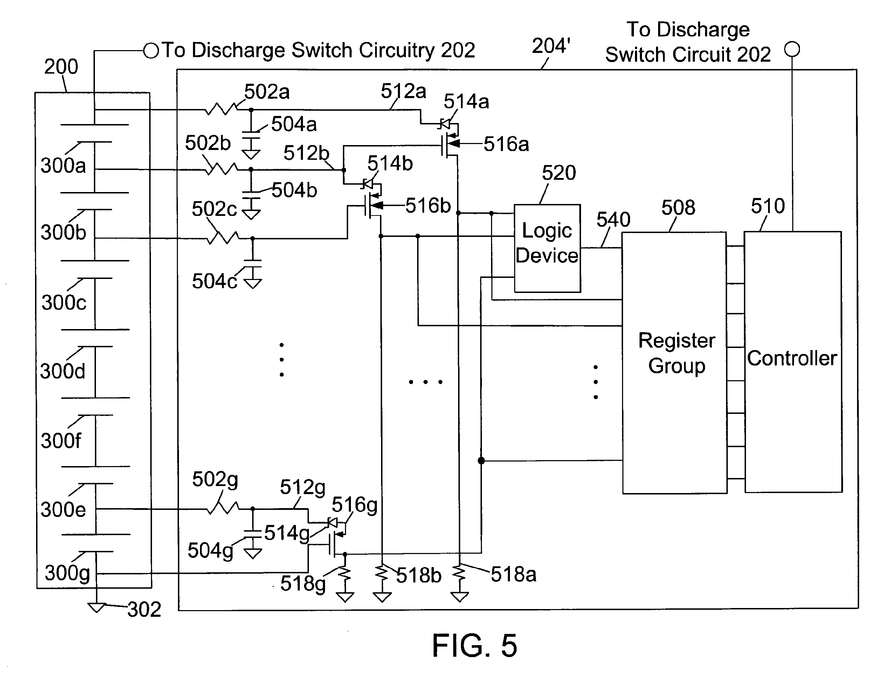

FIG. 5 illustrates a block diagram of a gas gauge (battery gauge) circuitry 204' with a monitoring circuitry for monitoring battery cell voltages, in accordance with one embodiment of the present invention. In one embodiment of the present invention, the monitoring circuitry is operable for monitoring voltages present on battery cells 300a-g. As illustrated in the example of FIG. 5, the battery gauge circuit 204' may include a monitoring circuitry, a register group 508 and a controller 510. The register group 508 and the controller 510 have the same functionality as the register group 320 and the controller 338 illustrated in FIG. 3. Therefore, any repetitive descriptions for the register group 508 and the controller 510 will be omitted herein for purposes of brevity and clarity.

In one embodiment, the monitoring circuit includes a plurality of voltage detection paths 512a, 512b, 512c (not shown), 512d (not shown), 512e (not shown), 512f (not shown), 512g, and a logic device (also known as combination logic component) 520. Each voltage detection path 512a-g is coupled to a battery cell 300a-g and is operable for comparing a cell voltage of the battery cell with a switch threshold (e.g., 3.6 volts) of a switch, in one embodiment. If a cell voltage detected by a certain voltage detection path is greater than the switch threshold, the voltage detection path is ON. Alternatively, if a cell voltage detected by a certain voltage detection path is less than the switch threshold, the voltage detection path is OFF. In one embodiment, the logic device 520 is coupled to voltage detection paths 512a-g and is operable for generating an alert signal 540 according to a conductance status of each voltage detection path 512a-g.

As shown in the example of FIG. 5, voltages present on battery cells 300a-g are first filtered by low pass filters that include resistors 502a, 502b, 502c, 502d (not shown), 502e (not shown), 502f (not shown), and 502g, and capacitors 504a, 504b, 504c, 504d (not shown), 504e (not shown), 504f (not shown), and 504g. For example, voltage detection path 512a detects a cell voltage filtered by a low pass filter that includes a resistor 502a and a capacitor 504a. Each voltage detection path may include a switch having a switch threshold, and a resistor (or a current source) coupled to the switch and a ground terminal 302. As illustrated in the example of FIG. 5, each switch includes a diode and a transistor coupled in series. Therefore, the switch threshold of each switch includes a summation of a diode threshold of the diode and a transistor threshold of the transistor. For example, the voltage detection path 512a may include a diode 514a and a transistor 516a connected in series, as shown in the example of FIG. 5. The voltage detection path 512a may further include a resistor 518a coupled between the switch (diode 514a and transistor 516a) and the ground terminal 302. Similarly, each voltage detection path 512b-g may respectively include diodes 514b, 514c (not shown), 514d (not shown), 514e (not shown), 514f (not shown), 514g, transistors 516b, 516c (not shown), 516d (not shown), 516e (not shown), 516f (not shown), 516g, and resistors 518b, 518c (not shown), 518d (not shown), 518e (not shown), 518f (not shown), 518g.

In one embodiment of the present invention, diodes 514a-g may be Zener diodes and transistors 516a-g may be metal oxide field effect transistors (MOSFETs). In voltage detection path 512a, the cathode of the Zener diode 514a is coupled to the resistor 502a, the anode of the Zener diode 514a is coupled to the source terminal of the MOSFET 516a. The gate terminal of the MOSFET 516a is coupled to the resistor 502b, and the drain terminal of the MOSFET 516a is coupled to the resistor 518a and the logic device 520. Since each Zener diode has a diode threshold and each MOSFET has a gate-source threshold, the switch threshold of the switch (including Zener diode 514a and MOSFET 516a) includes the summation of the diode threshold of the Zener diode 514a and the gate-source threshold of the MOSFET 516a, as shown in the example of FIG. 5. However, the implementation of the switch is not limited to a diode and a transistor coupled in series. In some other embodiments of the present invention, the implementation of the switch in each voltage detection path may include, but is not limited to, a diode, a transistor, or a plurality of diodes and transistors in combination. For example, in the example of FIG. 3, the switch in each voltage detection path is implemented by a transistor. Advantageously, the switch threshold can be adjusted by configuring the switch. For example, by increasing the number of diodes or change the type of the transistor, the switch threshold can be increased. In one embodiment, if a respective switch in a voltage detection path is close, then the respective voltage detection path is ON. If a respective switch in a voltage detection path is open, then the respective voltage detection path is OFF.

To detect if one or more voltages present on battery cells 300a-g have experienced an undesirable condition (e.g., an under-voltage condition), each voltage detection path may be connected to an input of the logic device 520. In one embodiment of the present invention, the logic device 520 may be an NOR gate having seven inputs (e.g. one for each voltage detection path 512a-g). However, other types of logic device such as AND gates, OR gates, Exclusive OR gates, and NAND gates may also be implemented individually or in combination without departing from the present disclosure. In one embodiment of the present invention, the logic device 520 generates an alert signal 540 according to a conductance status of each voltage detection path. The alert signal 540 can be used to place the cordless power tool 100 to a normal mode (normal state) or to a stand-by mode (stand-by state). For example, if the alert signal 540 is low (logic '0'), the normal mode will be enabled. If the alert signal 540 is high (logic '1'), the stand-by mode will be enabled. In the normal mode, power is delivered from battery cells 300a-g to a load (e.g., cordless power tool 100) via the discharge switch circuitry 202 and functions of the cordless power tool 100 are enabled, in one embodiment. In the stand-by mode, the discharge switch circuitry 202 is open. Thereby, power delivery from battery cells 300a-g to the cordless power tool 100 is halted and most functions of the cordless power tool 100 are disabled, in one embodiment.

In the example shown in FIG. 5, if the logic device 520 is implemented by a NAND gate, the logic device (NAND gate) 520 generates a high level alert signal 540 when the voltage present on at least one of battery cells 300a-g is below a switch threshold of the voltage detection path 512a-g. By receiving the high level alert signal, power delivery from battery cells 300a-g to the cordless power tool 100 is halted and the cordless power tool 100 enters the stand-by mode, in one embodiment. In the example shown in FIG. 5, if the logic device 520 is implemented by a NOR gate, the logic device (NOR gate) 520 generates a high level alert signal 540 when all the voltage detection paths 512a-g are OFF, which indicates that all the voltages present on battery cells 300a-g are below the switch threshold. Under such a circumstance, the high level alert signal 540 is used to halt power delivery from battery cells 300a-g to the cordless power tool 100, which places the cordless power tool 100 in the stand-by mode, in one embodiment.

During the operation of the cordless power tool 100, when any battery cell of battery cells 300a-g has a voltage greater than the switch threshold (e. g., 3.6 volts) of the corresponding switch, its corresponding voltage detection path 512a-g is ON as described above. As a result, a signal that represents the voltage present on a battery cell is provided to a resistor 518a-g of the voltage detection path 512a-g. For example, if voltage present on battery cell 300a is greater than the switch threshold (e.g., 3.6 volts), the switch (including diode 514a and transistor 516a) in the voltage detection path 512a is ON. Thus, a signal that represents the voltage present on battery cell 300a is provided to resistor 518a. Consequently, the corresponding input to the logic device 520 (or to the register group 508) is high. Under such a circumstance, the alert signal 540 generated at the output of the logic device 520 (NOR gate) is low, which enables the cordless power tool 100 to continue working in the normal mode, in one embodiment.

As the battery pack 200 further discharges, when all cell voltages of the battery pack 200 are below the switch threshold (e.g., 3.6 volts), voltage paths 512a-g will be OFF and all the inputs to the logic device 520 (NOR gate) are low, in one embodiment. Consequently, the alert signal 540 at the output of the logic device 520 (NOR gate) is high, which in turn switches the cordless power tool 100 into the stand-by state, in one embodiment. Furthermore, when all voltage detection paths 512a-g are OFF, a relatively small amount of current may flow through each voltage detection path. Thereby, the power consumption of the monitoring circuitry can be reduced, in one embodiment.

In the example of FIG. 5, the logic device 520 and voltage detection paths 512a-g are coupled to a plurality of registers in the register group 508. Each register of the plurality of registers can be used to store data that indicates a conductance status of each voltage detection path 512a-g. In addition, there is a register in the register group 508, which can be used to store data that indicates the logic level of the alert signal 540. In one embodiment of the present invention, if a voltage detection path of voltage detection paths 512a-g is ON, a logic "1" is stored in a register which stores data indicating the conductance status of that voltage detection path. Alternatively, if that voltage detection path is OFF, a logic "0" is stored in the aforementioned register. In one embodiment (e.g., logic device 520 is a NAND gate), if at least one voltage detection path 512a-g is OFF, a logic "1" is stored in the register which stores the logic level of the alert signal 540.

In one embodiment, the controller 510 is operable of receiving the alert signal 540 and halting power delivery to the cordless power tool 100 if at least one of the plurality of voltage detection paths 512a-g is OFF. The controller 510 may also access one or more registers in register group 508 to detect the logic level of the alert signal 540 and conductance status of each voltage detection path 512a-g. In the example of FIG. 5, by detecting that a logic "1" is stored in the register which stores logic level of the alert signal 540, the controller 510 may generate a signal to the discharge switch circuitry 202 to halt power delivery from battery cells 300a-g to the cordless power tool 100. Additionally, by accessing data that represent conductance statuses of voltage detection paths 512a-g, controller 510 may identify any OFF voltage detection paths 512a-g, that is, to identify which one or more battery cells have a deficient voltage level. According to a conductance status of each voltage detection path 512a-g, controller 510 may generate a signal to initiate an appropriate action or actions (e.g., initiate recharging of the identified battery cells).

Advantageously, in one embodiment, the gas gauge circuitry in the present invention detects an undesirable condition (e.g., under-voltage, over-voltage) by comparing a cell voltage with an internal switch threshold of a switch. As a result, the gas gauge circuitry in the present invention not only reduces detection time, but also reduces power consumption, in one embodiment. As described in the example of FIG. 5, the gas gauge circuitry 204' detects a voltage reduction (e.g., an under-voltage condition) during battery discharging. The gas gauge circuitry can also detect a voltage increase (e.g., an over-voltage condition) during battery charging.

In one embodiment of the present invention, the monitoring circuitry shown in FIG. 5 may be used to monitor voltage increases present on battery cells 300a-g by comparing voltages present on battery cells 300a-g with a switch threshold of a switch. For example, during a charging process of battery cells 300a-g, voltage present on each battery cell may increase. If a voltage present on a battery cell exceeds a high voltage threshold (over voltage), the battery cell may become damaged or hazardous. To ensure a safety charging of battery cells 300a-g, the switch in each voltage detection path can be configured, such that the switch threshold of the switch is equal to the high voltage threshold. For example, switches in voltage detection paths 512a-g may be implemented by a plurality of diodes and a transistor coupled in series. If the voltage present on a battery cell is greater than the high voltage threshold, the corresponding voltage detection path is ON, which indicates that the cell voltage of the battery cell exceeds the high voltage threshold. Consequently, the logic device 520 may generates the alert signal 540 to halt the charging process of battery cells 300a-g. Furthermore, the conductance status of each voltage detection path and the logic level of the alert signal 540 may be stored in register group 508 which can be accessed by the controller 510. According to the conductance status of each voltage detection path, controller 510 may generate a signal to initiate an appropriate action or actions (e.g., halting charging of one or more over voltage battery cells) to ensure the safety charging of the battery pack 200.

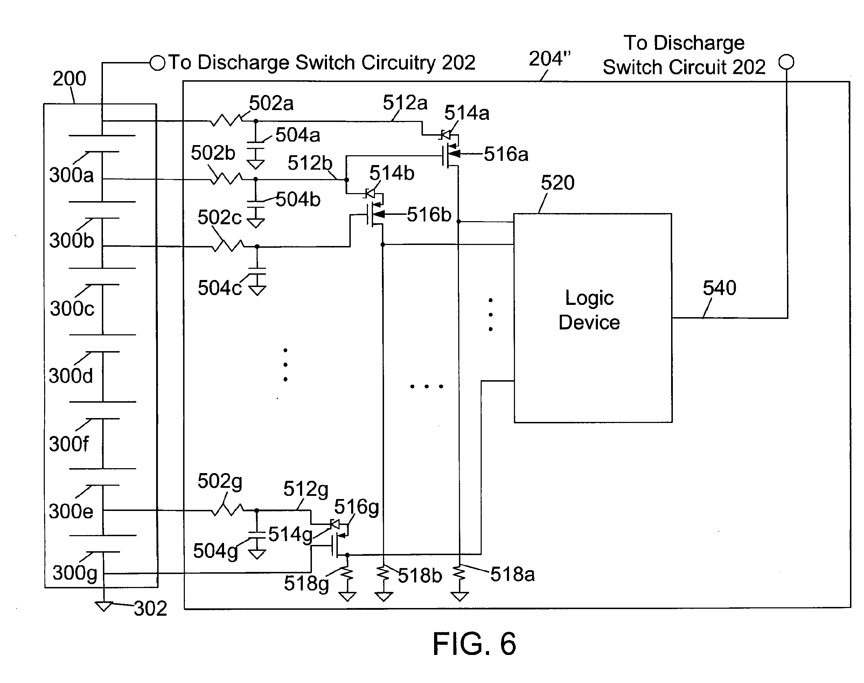

FIG. 6 illustrates another exemplary block diagram that represents an exemplary gas gauge circuitry 204" which includes a monitoring circuit for monitoring voltages present on the battery cells, in one embodiment. Elements that are labeled the same as in FIG. 5 have similar functions and will not be repetitively described herein for purposes of brevity and clarity. As shown in FIG. 6, the alert signal 540 generated by the logic device 520 can be used to control any kind of switch circuit (e.g., discharge switch circuit 202) directly.

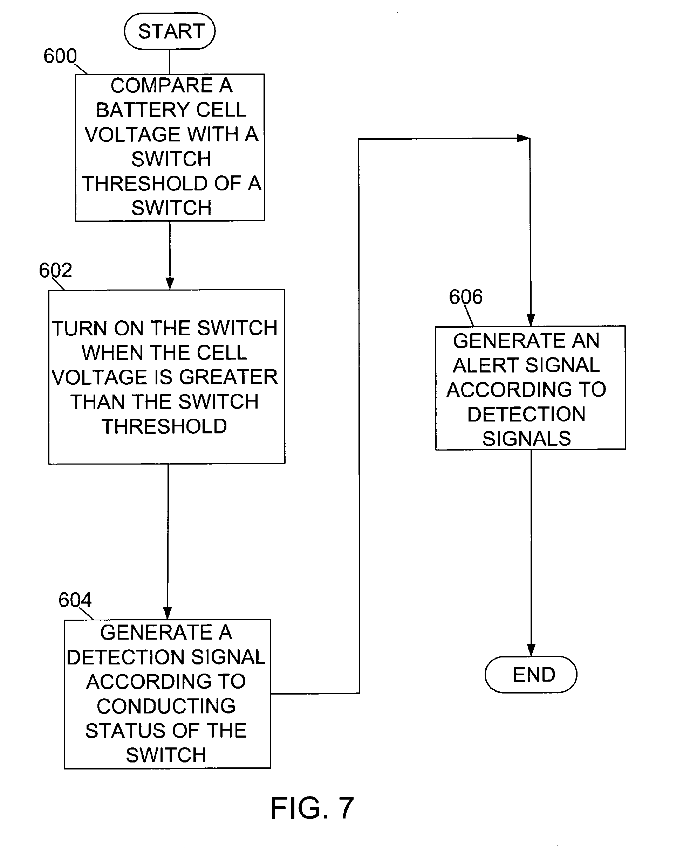

FIG. 7 illustrates an exemplary flowchart of a method for monitoring cell voltages of a battery pack. In order to monitor cell voltages of the battery pack, cell voltage of each battery cell is compared with a switch threshold of a switch, in block 600. If voltage present on the battery cell is greater than the switch threshold, the switch is ON, in block 602. Accordingly, a voltage detection path is ON (not shown). A detection signal for each battery cell is generated according to a conductance status of a switch (or according to a conductance status of a voltage detection path), in block 604. In one embodiment of the present invention, a detection signal having a relatively high voltage is generated if the switch (voltage detection path) is ON, which indicates that voltage present on the battery cell is greater than the switch threshold. If the switch (voltage detection path) is OFF, a detection signal having a relatively low voltage is generated, in one embodiment. Then, an alert signal is generated according to the detection signal for each battery cell, in block 606. In one embodiment of the present invention, if at least one detection signal is relatively low, then a high level alert signal is generated. However, in some other embodiments of the present invention, the high level alert signal may also be generated according to other combinations of statuses of detection signals. For example, the high level alert signal may be generated when all detection signals are relatively low. In one embodiment of the present invention, the switch threshold may be provided by a switch having a switch threshold. Each switch includes a diode and a transistor coupled in series, in one embodiment. Thus, the switch threshold of the switch is related to the summation of the diode threshold of the diode and the transistor threshold of the transistor. The switch threshold may also be adjusted by configuring the switch. For example, by increasing the number of diodes or changing the type of the transistor, the switch threshold can be increased accordingly.

A number of implementations have been described. Nevertheless, it will be understood that various modifications may be made. Accordingly, other implementations are within the scope of the following claims.

## Claims

1. A monitoring circuit comprising:
a plurality of voltage detection paths, wherein each voltage detection path of said plurality of voltage detection paths is coupled to a battery cell and is operable for comparing a cell voltage of said battery cell with a switch threshold of a switch, and wherein each voltage detection path is ON if said cell voltage is greater than said switch threshold; and
a logic device coupled to said plurality of voltage detection paths operable for generating an alert signal according to a conductance status of each voltage detection path.

2. The monitoring circuit of claim 1, wherein said switch comprises a transistor.

3. The monitoring circuit of claim 2, wherein said switch threshold comprises a transistor threshold of said transistor.

4. The monitoring circuit of claim 1, wherein said switch comprises a diode.

5. The monitoring circuit of claim 4, wherein said switch threshold comprises a diode threshold of said diode.

6. The monitoring circuit of claim 1, wherein said switch comprises a diode and a transistor.

7. The monitoring circuit of claim 6, wherein said switch threshold comprises a summation of a diode threshold of said diode and a transistor threshold of said transistor.

8. The monitoring circuit of claim 1, wherein each voltage detection path comprises a resistor coupled to said switch.

9. The monitoring circuit of claim 1, wherein each voltage detection path generates a detection signal according to said conductance status, which is received by said logic device.

10. A gas gauge circuitry comprising:
a plurality of voltage detection paths, wherein each voltage detection path of said plurality of voltage detection paths is coupled to a battery cell and is operable for comparing a cell voltage of said battery cell with a switch threshold of a switch, and wherein each voltage detection path is ON if said cell voltage is greater than said switch threshold;
a logic device coupled to said plurality of voltage detection paths operable for generating an alert signal according to a conductance status of each voltage detection path; and
a controller coupled to said logic device operable for receiving said alert signal, and for halting power delivery to a load if at least one of the plurality of voltage paths is OFF.

11. The gas gauge circuitry of claim 10, wherein said switch comprises a transistor.

12. The gas gauge circuitry of claim 11, wherein said switch threshold comprises a transistor threshold of said transistor.

13. The gas gauge circuitry of claim 10, wherein said switch comprises a diode.

14. The gas gauge circuitry of claim 13, wherein said switch threshold comprises a diode threshold of said diode.

15. The gas gauge circuitry of claim 10, wherein said switch comprises a diode and a transistor.

16. The gas gauge circuitry of claim 15, wherein said switch threshold comprises a summation of a diode threshold of said diode and a transistor threshold of said transistor.

17. The gas gauge circuitry of claim 10, wherein each voltage detection path comprises a resistor coupled to said switch.

18. The gas gauge circuitry of claim 10, wherein each voltage detection path generates a detection signal according to said conductance status, which is received by said logic device.

19. The gas gauge circuitry of claim 10, further comprising:
a plurality of registers, wherein each register of said plurality of registers is coupled to each voltage detection path and is operable for storing data which indicates said conductance status.

20. The gas gauge circuitry of claim 19, wherein said controller accesses said plurality of registers to identify an off voltage detection path of said plurality of voltage detection paths.

21. A method of monitoring cell voltages, comprising:
comparing a battery cell voltage for each battery cell of a plurality of battery cells with a switch threshold of a switch;
turing on said switch if said battery cell voltage is greater than said switch threshold;
generating a detection signal for each battery cell according to a conductance status of said switch, wherein said detection signal indicates whether said battery cell voltage is greater than said switch threshold.

22. The method of claim 21 further comprising:
generating an alert signal according to said detection signal.

23. The method of claim 21, wherein said switch comprises a transistor.

24. The method of claim 23, wherein said switch threshold comprises a transistor threshold of said transistor.

25. The method of claim 21, wherein said switch comprises a diode.

26. The method of claim 25, wherein said switch threshold comprises a diode threshold of said diode.
